# EUROPEAN PATENT SPECIFICATION

(11) **EP 1 580 606 B1**
(45) Date of publication and mention of the grant of the patent: **25.07.2012**
(21) Application number: 03775910.7
(22) Date of filing: 27.11.2003
(51) Int. Cl.: C11D 1/72, C11D 11/00, H01L 21/027

(54) **RINSE LIQUID FOR LITHOGRAPHY AND METHOD FOR FORMING RESIST PATTERN USING SAME**
REINIGUNGSFLÜSSIGKEIT FÜR LITHOGRAFIE UND VERFAHREN ZUR HERSTELLUNG EINER RESISTSTRUKTUR DAMIT
LIQUIDE DE RINÇAGE POUR LITHOGRAPHIE ET PROCEDE DE FORMATION D'UN MODELE DE RESERVE UTILISANT LEDIT LIQUIDE

(30) Priority: 03.12.2002 JP 2002350600
(43) Date of publication of application: 28.09.2005
(73) Proprietor: AZ Electronic Materials USA Corp., Somerville, NJ 08876 (US)
(72) Inventor: KOBAYASHI, Masakazu, Shizuoka 437-1496 (JP); ICHIKAWA, Hiroyuki, Daitocho, Ogasa-gun, Shizuoka 437-1496 (JP); YAMADA, Yoshiaki, Minato-ku, Tokyo 107-8481 (JP); TANAKA, Keiichi, Minato-ku, Tokyo 107-8481 (JP)
(74) Representative: Isenbruck, Günter
(86) International application number: PCT/JP2003/015150
(87) International publication number: WO 2004/051379

(56) References cited:
- WO-A1-99/15609
- JP-A- 11 184 099
- JP-A- 2000 338 685
- US-A- 5 002 857
- US-A1- 2001 001 703

## Description

### Technical Field

The present invention relates to use of a solution for a rinse treatment in lithography in a development process of a photosensitive resin composition applied for the manufacturing of a semiconductor device, a flat panel display (FPD) such as a liquid crystal display element, a color filter and so on according to claim 1 and to a pattern forming method using this rinse solution according to claim 5.

### Background Art

In the various fields such as manufacture of a semiconductor integrated circuit such as a LSI and a display face of a FPD, preparation of a color filter and a circuit substrate of, for example, a thermal head, and so on, photolithography technology has so far been employed for forming microelements or for conducting fine processing. In the photolithography method, a positive- or a negative-working photosensitive composition is used to form a resist pattern. Of these photosensitive compositions, a composition comprising an alkali-soluble resin and a compound containing a quinone diazide group as a photosensitizing agent is widely used.

By the way, a design rule is requiring recently a micronization from a half micron to a quarter micron or further finer in the microelectronic device manufacturing trade as a result of highly integrating tendency and a high speed tendency of a LSI. In order to respond to further micronization of such design rule, light-exposure sources so far applied such as a visible light or a near ultra violet light (wavelength, 400 to 300 nm) are not sufficient and it is becoming necessary to apply a deep ultra violet light such as KrF eximer laser (248 nm), ArF eximer laser (193 nm) and so on or a radiation having still shorter wavelength such as X-rays, electron beams and so on. Therefore, the lithography process using these light-exposure sources with shorter wavelengths is being proposed and is used in practice as a light-exposure source. In order to respond to a micronization of this design rule, a photosensitive resin composition which is used as a photoresist upon fine processing is being required to be one having a higher resolution. In addition, besides the resolution, an improvement of performance such as a sensitivity, a pattern form, an accuracy of image dimension and so on is also required for a photosensitive resin composition at the same time and "a chemically amplified photosensitive resin composition" is being proposed as a photosensitive resin composition having high resolution, which is sensitive to a radiation of shorter wavelength. Since this chemically amplified photosensitive resin composition is advantageous that a high sensitivity can be obtained by a catalytic image formation process by an acid, which is generated by irradiation of radiation from an acid generating compound contained in the chemically amplified photosensitive resin composition, it is replacing a photosensitive resin composition so far applied and is being prevailing.

However as a micronization is proceeding as described above, a problem of inclination of a pattern or peeling-off of a pattern after development in lithography process is becoming obvious. These problems of inclination of a pattern and peeling-off of a pattern tend to be particularly remarkable in a pattern formation having a high aspect ratio. As a method to solve this problem, a method was proposed to prevent inclination of a pattern or peeling-off of a pattern by improving an adhesive force between a resist and a substrate by conducting a surface treatment of the substrate or a film formation treatment onto a surface of the substrate. According to this method, it is possible to control the inclination of a pattern and peeling-off of a pattern to some extent. However, there is a limit to solve the problems by this method since a contacting area between a resist pattern and a substrate becomes smaller as the micronization is proceeding.

BY the way, causes why inclination of a pattern or peeling-off of a pattern take place after development in lithography process are known to be as follows. It means that a development treatment of a photoresist is conducted after exposure to light of the photoresist. After the development, a rinse (or cleaning) of a pattern by a rinse solution is conducted to wash a developing solution off from the resist pattern. At this time pure water is widely used as the rinse solution. However a surface tension of the pure water to be used as a rinse solution is very high. Upon rinsing a resist pattern by use of the rinse solution, a state wherein a rinse solution is pooled between patterns neighboring each other takes place in a drying process of rinsed patterns. When pure water is used as a rinse solution, the rinse solution pooled between neighboring patterns becomes a hollow state because of a surface tension thereof, negative pressure being generated between neighboring patterns by the surface tension of the rinse solution. And by the negative pressure, the neighboring patterns are pulled in each other upon drying a resist pattern. At this time if a difference of negative pressure which comes from a surface tension exists between a plural number of patterns, inclination of a pattern or peeling-off of a pattern takes place (which see Japanese examined patent publication No. Hei 6-105683, Japanese patent publication laid-open No. Hei 8-8163, Japanese patent publication laid-open No. Hei 7-142349, Japanese patent publication laid-open No. Hei 7-140674 and Japanese patent publication laid-open No. Hei 6-222570).

In order to solve the above described problems of inclination of a pattern or peeling-off of a pattern caused by the negative pressure which comes from a surface tension of a rinse solution staying between the patterns, many pattern forming methods have been reported such as a pattern forming method wherein a contact angle between a resist surface and a rinse solution is made in a certain limit by both a component adjustment of a photosensitive resin composition and an improvement of a resist surface by a developer or a rinse solution (Japanese examined patent publication No. Hei 6-105683, pp. 1 - 4), a pattern forming method wherein heated hot pure water, pure water containing a surfactant or an organic solvent being compatible with pure water is used as a final rinse solution (Japanese patent publication laid-open No. Hei 8-8163, pp. 1 - 3), a pattern forming method wherein a rinse solution is used of which a surface tension or a wetting property of a resist pattern is reduced by using a fluorine-containing surfactant as a surfactant or the like (Japanese patent publication laid-open No. Hei 7-142349, pp. 1 and 8), a pattern forming method wherein a rinse solution containing a solvent such as alcohol and having a particular degree of a surface tension isused (Japanesepatentpublicationlaid-openNo. Hei 7-140674, pp. 1, 2 and 4), a pattern forming method wherein a rinse solution with low viscosity such as hot water is used as a rinse solution (Japanese patent publication laid-open No. Hei 6-222570, pp. 2 and 3) and so on. However a rinse solution of low price and high safety, which can prevent inclination of a pattern or peeling-off of a pattern effectively towards a fine resist pattern of a high aspect ratio is strongly desired.

A method for the formation of resist patterns in which a solution which may comprise water and a nonionic surfactant having an ethyleneoxy group but not having a fluorine atom as alkaline developer solution is disclosed in US 2001/0001703. WO 99/15609 and JP 2000-338685 disclose rinsing solutions comprising water and a nonionic surfactant free of fluorine having an ethyleneoxy group for removing residues such as post-etch photoresist residues, metal depositions or deteriorated photoresist.

Referring to the above-described situation, the present invention has an object to offer a rinse solution for lithography, more in detail a rinse solution for lithography which can be applied preferably and suitably in a development process of a photosensitive resin composition for manufacturing of a semiconductor device, a flat panel display (FPD), a color filter, a circuit element and so on, which is low in price and high in safety and besides which can effectively prevent inclination of a pattern or peeling-off particularly in a fine resist pattern of a high aspect ratio; and to offer a pattern forming method using the same.

### Disclosure of Invention

As a result of eager studies and examinations, the present inventors found that by use of a rinse solution containing a nonionic surfactant without a fluorine atom but with an ethyleneoxy group (-CH₂CH₂O-) in water the above-described objects canbe attained, it means that by use of the rinse solution it is possible to form a good pattern at a low price and a high safety, without causing inclination of a pattern or peeling-off of a pattern particularly in a fine pattern with a high aspect ratio to reach to the present invention.

That is, the present invention relates to the use of a solution containing water and a nonionic surfactant having an ethyleneoxy group (-CH2-CH2-O-), but not having a fluorine atom, in lithography for conducting a rinsing treatment of a resist pattern after development.

The present invention also relates to a resist pattern forming method which is characterized in conducting a rinsing treatment of a pattern after development by use of the above-described rinse solution for lithography.

### Detailed Description of the Invention

Hereinafter, the present invention will be further described in more detail.

First, as water used in the rinse solution for lithography, there is preferably illustrated water wherein organic impurities, metal ions and so on are removed by a distillation, an ion exchange treatment, a filtration treatment, a various kind of absorption treatments and so on, and particularly preferred is pure water.

Next the surfactant used in the rinse solution for lithography may be any nonionic surfactant having an ethyleneoxy group (-CH₂CH₂O-) but having no fluorine atom. As the representative nonionic surfactants used in the rinse solution of the present invention there are exemplified, for example, the following nonionic surfactants (a) to (h). It needs no saying that the nonionic surfactants used in the rinse solution are not limited in those illustrated as representative examples.
(a) R-CO·O(-CH₂-CH₂-O-)ₙ H
(b) R-CO·NX (-CH₂-CH₂-O-)ₙ H
(c) R-O(-CH₂-CH₂-O-)ₙ H
(d) R-NX (-CH₂-CH₂-O-)ₙ H
(e) R-S(-CH₂-CH₂-O-)ₙ H
(f) R-Ph-O(-CH₂-CH₂-O-)ₙ H
(g) A block copolymer of polyethylene glycol and polypropylene glycol
(h) An ethylene oxide adduct or an ethyleneoxide and a propylene oxide adduct of acetylene alcohols or acetylene glycols

In the formulae (a) to (f) described above, R represents a saturated or unsaturated and substituted or not substituted alkyl group having no fluorine atom, X represents H or (-CH₂-CH₂-O-)ₙ H, Ph represents a phenylene group, and n represents a positive integer each independently. Further as representative acetylene alcohols and acetylene glycols, there are exemplified compounds represented by the following general formulae (A) and (B): 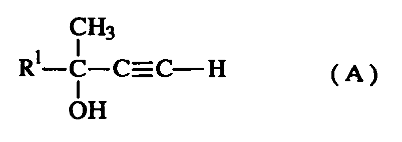 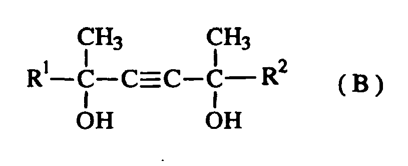 wherein R¹ and R² represent linear or branched alkyl group which may be the same or different each other.

Preferred concrete examples of above-described nonionic surfactants used in the rinse solution for lithography include Pyonine D-225 manufactured by Takemoto Oil & Fats Co., Ltd. (polyoxyethylene castoroil ether) , Pyonine D-2506D (polyethylene glycol dioleyl ester), Pyonine D-3110 (polyoxyethylene alkyl amino ether), Pyonine P-1525 (polyethylene glycol·polypropylene glycol block copolymer), Surfinol 420 manufactured by Air Products & Chemicals Inc., Surfinol 440 ( 1 mole of and 3.5 moles of polyethylene oxide adduct of acetylene glycols, respectively), Surfinol 2502 (5 moles of ethylene oxide and 2 moles of propylene oxide adduct of acetylene glycols) and so on. As the above-described nonionic surfactants used in the present invention are commercially available in a various kinds, these can come to hand easily. In addition, these are low in price and excellent in safety.

In the present invention, nonionic surfactants can be used singly or concurrently with two or more kinds. The nonionic surfactants according to the use of the present invention are used usually in an amount of 20 to 5,000 ppm, and preferably 50 to 3,000 ppm in a rinse solution for lithography. In the case where the content thereof is less than 20 ppm, it is likely that an effect by addition of the surfactant is hardly exhibited, and as a result an incidence ratio of inclination of a pattern or peeling-off of a pattern becomes high. On the other side, in the case where it is higher than 5,000 ppm, it is likely that swelling of a pattern and so on take place easily and a incidence ratio of inclination of a pattern or peeling-off of a pattern often becomes high.

In addition, in the present invention a water-soluble organic solvent may be further added to the rinse solution, if necessary in order to improve a surface tension or a wetting property to a photoresist of the rinse solution. These solvents are used as homogeneous liquid with water. The water-soluble organic solvent has no limit particularly if it is soluble in water by 0.1 weight-% or more. And examples of the water-soluble organic solvents include alcohols such as methyl alcohol, ethyl alcohol and isopropyl alcohol, ketones such as acetone and methyl ethyl ketone, esters such as methyl acetate, ethyl acetate and ethyl lactate, dimethyl formamide, dimethyl sulfoxide, methyl cellosolve, cellosolve, butyl cellosolve, cellosolve acetate, alkyl cellosolve acetate, propylene glycol alkyl ether, propylene glycol alkyl ether acetate, butyl carbitol, carbitol acetate, tetrahydrofuran and so on. These concrete examples are raised only as examples of organic solvents and the solvents used in the present invention are not limited with these solvents. These solvents are often applied usually in an amount of 10 parts by weight or less relative to 100 parts by weight of water.

Next, a resist pattern forming method wherein a rinse solution of the present invention is applied will now be explained. A lithography process of the present invention may be any one of methods which are publicly known as methods of forming a resist pattern using a positive-working photosensitive resin composition or a negative-working photosensitive resin composition.

As a representative resist pattern forming method wherein a rinse solution of the present invention is applied, there is illustrated the following method.

First, a photosensitive resin composition is applied by an application method so far publicly known such as a spin coating method on a silicon substrate, glass substrate or the like which is pre-treated if necessary. Prior to the application of the photosensitive resin composition or on a resist film formed by application, an anti-reflective coating may be formed by application, if necessary. The photosensitive resin composition applied on a substrate is pre-baked on a hotplate. By this pre-baking, solvent is removed from the composition to form a photoresist film with thickness of about 0.5 to 2.5 microns usually. Pre-baking temperature differs depending on a solvent or a photosensitive resin composition to be used, but it is usually about 20 to 200°C, preferably about 50 to 150°C. The photoresist film is thereafter exposed to light through a mask if necessary, using a publicly known irradiation device such as a high pressure mercury lamp, a metal halide lamp, a super high pressure mercury lamp, a KrF eximer laser, an ArF eximer laser, a soft X ray irradiation device, and an electron beam drawing device. Following to the exposure to light, baking is conducted if necessary. Then it is developed by a method such as a puddle development, for example, and a resist pattern is formed. The development of a resist is conducted usually by use of an alkali developer. As an alkali developer, an aqueous or water solution of sodium hydroxide, tetramethyl ammonium hydroxide (TMAH) or the like, for example, is used. After the developing treatment, a resist pattern is rinsed by use of a rinse solution. By the way the formed resist pattern is used as a resist for etching, plating, ion diffusion, dying treatment and so on, thereafter it is removed if necessary.

The rinse solution for lithography of the present invention can be applied for a resist pattern which is formed with any photosensitive resin composition. As representatives among ones for which the rinse solution for lithography of the present invention can be applied, there are exemplified a photosensitive resin composition comprising a quinone diazide photosensitizer and an alkali-soluble resin, a chemically amplified photosensitive resin composition and so on for a positive-working type, a photosensitive resin composition containing a high molecular compound having a photosensitive group such as polyvinylcinnamate, a photosensitive resin composition containing an azide compound such as one containing an aromatic azide compound and one comprising a cyclic rubber and a bisazide compound, one containing a diazo resin, a photo-polymerizable composition containing an addition polymerizable unsaturated compound, and a negative-working chemically amplified photosensitive resin composition for a negative-working type.

A positive-working photosensitive resin composition comprising a quinone diazide photosensitizer and an alkali-soluble resin is raised as a photosensitive resin composition for which the rinse solution for lithography of the present invention can be applied preferably and suitably. As concrete example of the quinone diazide photosensitizer and the alkali-soluble resin used for the positive-working photosensitive resin composition comprising a quinone diazide photosensitizer and an alkali-soluble resin, there can be exemplified, as a quinone diazide photosensitizer, 1,2-benzoquinonediazide-4-sulfonic acid, 1,2-naphthoquinonediazide-4-sulfonic acid, 1, 2-naphthoquinonediazide-5-sulfonic acid, and ester or amide of those sulfonic acids, and as an alkali-soluble resin, novolak resin, polyvinylphenol, polyvinylalcohol, and a copolymer of acrylic acid or methacrylic acid. As preferred novolak resins, one which is manufactured from one or two or more kinds of phenols such as phenol, o-cresol, m-cresol, p-cresol, xylenol and so on and one or more kinds of aldehydes such as formaldehyde, paraformaldehyde and so on is raised.

A chemically amplified photosensitive resin composition is a preferable photosensitive resin composition to be applied for a rinse solution of the present invention even if it is a positive-working type or a negative-working type. The chemically amplified resist forms a pattern by changing the solubility of a irradiated area in a developer by a chemical change caused from a catalytic action of an acid which is generated by irradiation of radiation. For example, as chemically amplified photosensitive resin compositions, there can be noted one which generates an acid by irradiation of radiation and a resin containing an acid responsive group which is decomposed in the presence of an acid to form an alkali-soluble group such as a phenolic hydroxyl group or a carboxyl group, and one comprising an alkali-soluble resin, a crosslinking agent and an acid-generating compound.

The rinse solution for lithography of the present invention can prevent effectively inclination of a pattern or peeling-off of a pattern particularly for a fine resist pattern having a high aspect ratio. Therefore, as a preferred method of forming a resist pattern to which the rinse solution is applied, a method is noted by which such a fine resist pattern is formed by a lithography process, wherein an exposure to light at the light-exposure wavelength of 250 nm or less is conducted by use of a KrF eximer laser or an ArF eximer laser or further an X-ray or an electron beam and so on as a light-exposure source. In addition from the viewing point of a pattern dimension of a resist pattern, a resist pattern forming process containing a lithography process to form a resist pattern having 300 nm or less of a line width for a line and space pattern or a hole diameter for a contact hole pattern is preferred.

The rinse solution may either be used as only a final rinse solution after rinsing a resist pattern formed by development using water such as pure water or to conduct a rinse treatment of a resist pattern formed by development using only the rinse solution. However, application methods of the rinse solution are not limited in these methods. For example, it may be applied by the method to conduct a rinse treatment of a pattern using water if necessary, followed by a rinse treatment of a pattern using a rinse solution and then conducting a rinsing treatment using water such as pure water.

### Best Mode for Carrying Out the Invention.

The present invention will now be described more specifically by reference to Examples which, however, are not to be construed to limit the present invention in any way.

### Examples 1 to 22 and Comparative Examples 1 to 11 (Preparation of rinse solutions)

Rinse solutions R-1 to R-33 were prepared by adding to pure water surfactants A to I in Table 1 at the concentrations in Table 2 and Table 3, respectively, and then agitating for an hour at the ordinary temperature to dissolve the surfactants.

**Table 1**

| | Name of surfactant | With or without an oxyethylene group | Type |
|---|---|---|---|
| A | Pyonine D-225 | with | nonionic |
| B | Pyonine D-2506D | with | nonionic |
| C | Pyonine D-3110 | with | nonionic |
| D | Pyonine P-1525 | with | nonionic |
| E | Surfinol 420 | with | nonionic |
| F | Surfinol 440 | with | nonionic |
| G | Pyonine A-70-F | without | anionic |
| H | Pyonine B-231 | without | cationic |
| I | Pyonine C-157A | without | amphoteric |

In the table, surfactant A represents polyoxyethlene castor oil ether, surfactant B represents polyethylene glycol dioleyl ester, surfactant C represents polyoxyethlene alkylamino ether, surfactant D represents a block copolymer of polyethylene glycol and polypropylene glycol, surfactant E represents an ethylene oxide adduct of acetylene glycols, surfactant F represents a polyethylene oxide adduct of acetylene glycols, surfactant G represents dioctylphosphate, surfactant H represents C₁₂ alkyldimethylbenzylammonium chloride, surfactant I represents C₁₂ alkyldimethylbetaine.

**Table 2**

| Example | Rinse solution | Surfactant | Concentration (ppm) |
|---|---|---|---|
| 1 | R-1 | A | 100 |
| 2 | R-2 | A | 1000 |
| 3 | R-3 | A | 3000 |
| 4 | R-4 | B | 100 |
| 5 | R-5 | B | 300 |
| 6 | R-6 | B | 500 |
| 7 | R-7 | B | 2000 |
| 8 | R-8 | C | 50 |
| 9 | R-9 | C | 100 |
| 10 | R-10 | C | 500 |
| 11 | R-11 | C | 3000 |
| 12 | R-12 | D | 100 |
| 13 | R-13 | D | 300 |
| 14 | R-14 | D | 500 |
| 15 | R-15 | D | 1000 |
| 16 | R-16 | D | 2000 |
| 17 | R-17 | E | 50 |
| 18 | R-18 | E | 100 |
| 19 | R-19 | E | 500 |
| 20 | R-20 | F | 50 |
| 21 | R-21 | F | 100 |
| 22 | R-22 | F | 500 |

**Table 3**

| Comparative Example | Rinse solution | Surfactant | Concentration (ppm) |
|---|---|---|---|
| 1 | R-23 | without | - |
| 2 | R-24 | G | 100 |
| 3 | R-25 | G | 1000 |
| 4 | R-26 | G | 3000 |
| 5 | R-27 | G | 5000 |
| 6 | R-28 | H | 200 |
| 7 | R-29 | H | 500 |
| 8 | R-30 | H | 1500 |
| 9 | R-31 | I | 100 |
| 10 | R-32 | I | 1000 |
| 11 | R-33 | I | 3000 |

### Example 23

An anti-reflective coating AZ KrF-17B manufactured by Clariant Company was spin-coated on a 6-inch silicon wafer by a spin coater manufactured by Tokyo Electron Co., Ltd. and pre-baked on a hotplate at 190°C for 90 seconds to be prepared as forming a film of 800 angstroms in thickness. Film thickness was measured by a film thickness measurement device manufactured by Prometrisc Inc. Next, photoresist AZ DX5160P ("AZ" is a registered trademark, hereafter the same.) manufactured by Clariant Company was spin-coated on the obtained anti-reflective coating and pre-baked on a hotplate at 130°C for 60 seconds to be prepared as forming a resist film of 0.51 µm in thickness. After that it was exposed to light by a reduction projection light-exposure device, FPA3000EX5 (exposure wavelength 248 nm) manufactured by Canon Co. using 2/3 Annuler. After exposure to light, it was baked on a hotplate at 110°C for 60 seconds and puddle-developed with a developer, AZ 300MIF Developer manufactured by Clariant Company (2.38 weight-% tetramethylammonium hydoxide aqueous solution) at 23°C for a minute. Next, after being rinsed with pure water, a rinsing treatment with a rinse solution R-1 of Example 1 was conducted, followed by spin-drying to obtain a resist pattern. A 1:1 line and space pattern having a pattern size of 140 nm of the obtained resist pattern was observed by a surface inspection device KLA manufactured by KLA Tencole Inc. and the evaluation for inclination (peeling-off) of a pattern was conducted. The result was shown in Table 4.

In addition, the evaluation of inclination of a pattern and calculation of incidence rate of inclination of a pattern was as following. That is, when even one pattern was found in a tested substance during inspection of the specimens, it was counted as one with inclination of a pattern in the tested substances and an incidence rate of pattern inclination was calculated as a rate of substances with inclination of a pattern in plural number of tested substances.

### Examples 24 to 44

The same procedures as in Example 1 were carried out except using rinse solutions R-2 to R-22 respectively in place of the rinse solution R-1 to obtain the results in Table 4.

**Table 4**

| Example | Rinse solution | Surfactant | Incidence rate of pattern inclination (%) |
|---|---|---|---|
| 23 | R-1 | A | 0 |
| 24 | R-2 | A | 0 |
| 25 | R-3 | A | 15 |
| 26 | R-4 | B | 0 |
| 27 | R-5 | B | 0 |
| 28 | R-6 | B | 0 |
| 29 | R-7 | B | 10 |
| 30 | R-8 | C | 0 |
| 31 | R-9 | C | 0 |
| 32 | R-10 | C | 0 |
| 33 | R-11 | C | 10 |
| 34 | R-12 | D | 0 |
| 35 | R-13 | D | 0 |
| 36 | R-14 | D | 0 |
| 37 | R-15 | D | 0 |
| 38 | R-16 | D | 10 |
| 39 | R-17 | E | 0 |
| 40 | R-18 | E | 0 |
| 41 | R-19 | E | 0 |
| 42 | R-20 | F | 0 |
| 43 | R-21 | F | 0 |
| 44 | R-22 | F | 0 |

### Comparative Example 12 to 22

The same procedures as in Example 1 were carried out except using rinse solutions R-23 to R-33 in place of rinse solution R-1 to obtain the result of Table 5.

**Table 5**

| Comparative Example | Rinse solution | Surfactant | Incidence rate of pattern inclination (%) |
|---|---|---|---|
| 12 | R-23 | without | 100 |
| 13 | R-24 | G | 100 |
| 14 | R-25 | G | 100 |
| 15 | R-26 | G | 100 |
| 16 | R-27 | G | 100 |
| 17 | R-28 | H | 100 |
| 18 | R-29 | H | 100 |
| 19 | R-30 | H | 100 |
| 20 | R-31 | I | 100 |
| 21 | R-32 | I | 100 |
| 22 | R-33 | I | 100 |

### Example 45

An anti-reflective coating AZ ArF1C5D manufactured by Clariant Company was spin-coated on a 6 inch silicon wafer by a spin coater manufactured by Tokyo Electron Co., Ltd., and then pre-baked on a hotplate at 200°C for 60 seconds to be prepared as forming a film of 390 angstroms in thickness. The film thickness was measured by a film thickness measurement device manufactured by Prometrisc Inc. Next, photoresist AZ Exp. T9479 manufactured by Clariant Company was spin-coated on the obtained anti-reflective coating, was pre-baked at 130°C for 60 seconds to be prepared as forming a resist film of 0.44 µm in thickness. After that it was exposed to light by Stepper NSR-305B (exposure wavelength is 193 nm) manufactured by Nikon Co. using 2/3 Annuler. After exposure to light, it was baked on a hotplate at 110°C for 60 seconds and puddle-developed with a developer, AZ 300MIF Developer manufactured by Clariant Company (2.38 weight-% tetramethylammonium hydroxide aqueous solution) at 23°C for a minute. Next, after being rinsed with pure water, a rinsing treatment with a rinse solution R-1 of Example 1 was conducted, followed by spin-drying to obtain a resist pattern. A 1:1 line and space pattern having a pattern size of 130 nm of the obtained resist pattern was observed by a surface inspection device KLA and the evaluation for inclination of a pattern was conducted. The result was shown in Table 6.

### Examples 46 to 66

The same procedures as in Example 45 were carried out except using rinse solutions R-2 to R-22 respectively in place of instead of R-1 to obtain the results in Table 6.

**Table 6**

| Example | Rinse solution | Surfactant | Incidence rate of pattern inclination (%) |
|---|---|---|---|
| 45 | R-1 | A | 0 |
| 46 | R-2 | A | 0 |
| 47 | R-3 | A | 15 |
| 48 | R-4 | B | 0 |
| 49 | R-5 | B | 0 |
| 50 | R-6 | B | 0 |
| 51 | R-7 | B | 0 |
| 52 | R-8 | C | 0 |
| 53 | R-9 | C | 0 |
| 54 | R-10 | C | 0 |
| 55 | R-11 | C | 0 |
| 56 | R-12 | D | 0 |
| 57 | R-13 | D | 0 |
| 58 | R-14 | D | 0 |
| 59 | R-15 | D | 0 |
| 60 | R-16 | D | 10 |
| 61 | R-17 | E | 0 |
| 62 | R-18 | E | 0 |
| 63 | R-19 | E | 0 |
| 64 | R-20 | F | 0 |
| 65 | R-21 | F | 0 |
| 66 | R-22 | F | 0 |

### Comparative Examples 23 to 33

The same procedures as in Example 45 were carried out except using rinse solutions R-23 to R-33 respectively in place of R-1 to obtain the results in Table 7.

**Table 7**

| Comparative Example | Rinse solution | Surfactant | Incidence rate of pattern inclination (%) |
|---|---|---|---|
| 23 | R-23 | without | 100 |
| 24 | R-24 | G | 100 |
| 25 | R-25 | G | 100 |
| 26 | R-26 | G | 100 |
| 27 | R-27 | G | 100 |
| 28 | R-28 | H | 100 |
| 29 | R-29 | H | 100 |
| 30 | R-30 | H | 100 |
| 31 | R-31 | I | 100 |
| 32 | R-32 | I | 100 |
| 33 | R-33 | I | 100 |

### Example 67

A photoresist manufactured by Clariant Company, AZ EXP. 5555 was spin-coated on a 6 inch silicon wafer by a spin coater manufactured by Tokyo Electron Co., Ltd., and then pre-baked on a hotplate at 110°C for 120 seconds to be prepared as forming a film of 0.275 µm in thickness. The film thickness was measured by a film thickness measurement device manufactured by Prometrisc Inc. Next, after being irradiated with electron beam (EB) by an electron beam irradiation device HLD-800 manufactured by Hitachi Co., Ltd., the coating was baked at 110°C for 120 seconds. After that, it was puddle-developed by a developer, AZ 300MIF Developer manufactured by Clariant Company (2.38 weight-% tetramethylammonium hydroxide aqueous solution) at 23°C for a minute. After the development, it was rinsed with pure water and a rinsing treatment with a rinse solution R-1 of Example 1 was conducted, followed by spin-drying to obtain a resist pattern. The resulting 1:1 line and space pattern having a pattern size of 80 nm was observed by a surface inspection device KLA and the evaluation for inclination of a pattern was conducted. The result was shown in Table 8.

### Examples 68 to 87

The same procedures as in Example 67 were carried out except using rinse solutions R-2 to R-15 and R-17 to R-22 respectively in place of R-1 to obtain the results in Table 8.

**Table 8**

| Example | Rinse solution | Surfactant | Incidence rate of pattern inclination (%) |
|---|---|---|---|
| 67 | R-1 | A | 0 |
| 68 | R-2 | A | 0 |
| 69 | R-3 | A | 0 |
| 70 | R-4 | B | 0 |
| 71 | R-5 | B | 0 |
| 72 | R-6 | B | 0 |
| 73 | R-7 | B | 10 |
| 74 | R-8 | C | 0 |
| 75 | R-9 | C | 0 |
| 76 | R-10 | C | 0 |
| 77 | R-11 | C | 10 |
| 78 | R-12 | D | 0 |
| 79 | R-13 | D | 0 |
| 80 | R-14 | D | 0 |
| 81 | R-15 | D | 10 |
| 82 | R-17 | E | 0 |
| 83 | R-18 | E | 0 |
| 84 | R-19 | E | 0 |
| 85 | R-20 | F | 0 |
| 86 | R-21 | F | 0 |
| 87 | R-22 | F | 0 |

### Comparative Example 34 to 44

The same procedures as in Example 67 were carried out except using rinse solutions R-23 to R-33 respectively in place of R-1 to obtain the results in Table 9.

**Table 9**

| Comparative Example | Rinse solution | Surfactant | Incidence rate of pattern inclination (%) |
|---|---|---|---|
| 34 | R-23 | without | 100 |
| 35 | R-24 | G | 100 |
| 36 | R-25 | G | 100 |
| 37 | R-26 | G | 100 |
| 38 | R-27 | G | 100 |
| 39 | R-28 | H | 100 |
| 40 | R-29 | H | 100 |
| 41 | R-30 | H | 100 |
| 42 | R-31 | I | 100 |
| 43 | R-32 | I | 100 |
| 44 | R-33 | I | 100 |

### Example 88

An anti-reflective coating AZ KrF-17B manufactured by Clariant Company was spin-coated on a 6 inch silicon wafer by a spin coater manufactured by Tokyo Electron Co., Ltd., and then pre-baked on a hotplate at 190°C for 90 seconds to be prepared as forming a film of 800 angstroms in thickness. The film thickness was measured by a film thickness measurement device manufactured by Prometrisc Inc. Next, a photoresist AZ DX5160P manufactured by Clariant Company was spin-coated on the obtained anti-reflective coating, and pre-baked at 130°C for 60 seconds to be prepared as forming a resist film of 0.51 µm in thickness. After that it was exposed to light by a reduction projection light-exposure device, FPA3000EX5 (exposure wavelength is 248 nm) manufactured by Canon Co. using 2/3 Annuler and changing a focus thereof and 9 pieces of 1:1 line and space pattern were stepwise exposed to light, thereafter it was baked on a hotplate at 110°C for 60 seconds and puddle-developed by a developer, AZ 300MIF Developer manufactured by Clariant Company (2.38 weight-% tetramethylammonium hydoxide aqueous solution) at 23°C for a minute. Following to the development, it was rinsed with pure water, and a rinsing treatment with the rinse solution R-1 of Example 1 was conducted, followed by spin-drying to obtain nine resist patterns having 1:1 line and space pattern having a pattern size of 140 nm of a resist patterns were obtained. The resulting resist patterns were observed by scanning electronic microscope manufactured by Hitachi Co., Ltd. and the evaluation of DOF (Depth of Focus) was conducted. DOF value showed a limit of focus wherein resist patterns were obtained without pattern inclination for all 9 patterns after final rinsing. As the position of focus deviates from the optimal focus, patterns at the both edges of 9 pieces of a line and space pattern are easy to incline because of an amount of light upon light-exposure. The result was shown in Table 10.

### Examples 89 to 109

The same procedures as in Example 88 were carried out except using rinse solutions R-2 to R-22 respectively in place of R-1 to obtain the results in Table 10.

**Table 10**

| Example | Rinse solution | Surfactant | DOF (µm) |
|---|---|---|---|
| 88 | R-1 | A | 0.4 |
| 89 | R-2 | A | 0.4 |
| 90 | R-3 | A | 0.4 |
| 91 | R-4 | B | 0.2 |
| 92 | R-5 | B | 0.4 |
| 93 | R-6 | B | 0.4 |
| 94 | R-7 | B | 0.4 |
| 95 | R-8 | C | 0.4 |
| 96 | R-9 | C | 0.4 |
| 97 | R-10 | C | 0.4 |
| 98 | R-11 | C | 0.4 |
| 99 | R-12 | D | 0.4 |
| 100 | R-13 | D | 0.4 |
| 101 | R-14 | D | 0.4 |
| 102 | R-15 | D | 0.4 |
| 103 | R-16 | D | 0.4 |
| 104 | R-17 | E | 0.4 |
| 105 | R-18 | E | 0.4 |
| 106 | R-19 | E | 0.4 |
| 107 | R-20 | F | 0.4 |
| 108 | R-21 | F | 0.4 |
| 109 | R-22 | F | 0.4 |

### Comparative Examples 45 to 55

The same procedures as in Example 88 were carried out except using rinse solutions R-23 to R-33 respectively in place of R-1 to obtain the results in Table 11.

**Table 11**

| Comparative Example | Rinse solution | Surfactant | DOF (µm) |
|---|---|---|---|
| 45 | R-23 | without | 0.2 |
| 46 | R-24 | G | 0.2 |
| 47 | R-25 | G | 0.2 |
| 48 | R-26 | G | 0.2 |
| 49 | R-27 | G | 0.2 |
| 50 | R-28 | H | 0.2 |
| 51 | R-29 | H | 0.2 |
| 52 | R-30 | H | 0.2 |
| 53 | R-31 | I | 0.2 |
| 54 | R-32 | I | 0.2 |
| 55 | R-33 | I | 0.2 |

From Table 10 and Table 11, it was proved that inclination of a pattern after rinsing became hard to take place by use of the rinse solution of the present invention, and a light-exposure latitude towards deviation of focus upon exposure to light was also improved.

In the above description, the result with an order of development → pure water → rinse solution as a sequence of the rinse solution was shown, however the same results were obtained when conducting with a sequence of development → rinse solution or a sequence of development → pure water → rinse solution → pure water.

Further when baking treatment is conducted after rinsing treatment of the present invention, the effectiveness to prevent swelling of a resist pattern can be obtained.

### Effect of the Invention

As mentioned above, the use of a solution for a rinsing treatment in litography according to the present invention is low in price and safe, can prevent inclination of a pattern or peeling-off of a pattern, and particularly is suitable for forming a resist pattern having a high aspect ratio.

## Claims

1. The use of a solution, comprising water and a nonionic surfactant having an ethyleneoxy group (-CH₂CH₂O-) but not having a fluorine atom, in lithography for conducting a rinsing treatment of a resist pattern after development.

2. The use according to claim 1, **characterized in that** the solution consists of water, the nonionic surfactant and optionally a water soluble organic solvent.

3. The use according to claim 1 or 2, **characterized in that** the concentration of the nonionic surfactant described above is from 20 to 5,000 ppm.

4. The use according to any one of claims 1 to 3, **characterized in that** the nonionic surfactant is at least one member selected from the group consisting of an ethylene oxide adduct or an ethylene oxide and a propylene oxide adduct of acetylene alcohols or acetylene glycols, polyoxyethylene castor oil ether, polyethylene glycol dioleyl ester, polyoxyethylene alkylamino ether, and a block copolymer of polyethylene glycol and polypropylene glycol.

5. A resist pattern forming method comprising the step of conducting a rinsing treatment of a resist pattern after development, **characterized in that** the rinse solution for lithography is a solution according to any one of claims 1 to 4.

6. The resist pattern forming method according to claim 5 **characterized in that** the resist patterns contain a resist pattern having a pattern dimension of 300 nm or less.

7. The resist pattern forming method according to claim 5 or 6, **characterized in that** the resist pattern is formed in a lithography process comprising an exposure to light at a light-exposure wavelength of 250 nm or less.

## Patentansprüche

1. Verwendung einer Lösung, enthaltend Wasser und ein nichtionisches Tensid mit einer Ethylenoxygruppe (-CH₂CH₂O-), aber keinem Fluoratom, in der Lithographie zur Durchführung einer Spülbehandlung eines Resistmusters nach der Entwicklung.

2. Verwendung gemäß Anspruch 1, **dadurch gekennzeichnet, dass** die Lösung aus Wasser, dem nichtionischen Tensid und gegebenenfalls einem wasserlöslichen organischen Lösungsmittel besteht.

3. Verwendung gemäß Anspruch 1 oder 2, **dadurch gekennzeichnet, dass** die Konzentration des oben beschriebenen nichtionischen Tensids zwischen 20 und 5000 ppm liegt.

4. Verwendung gemäß einem der Ansprüche 1 bis 3, **dadurch gekennzeichnet, dass** das nichtionische Tensid mindestens ein Mitglied ist gewählt aus der Gruppe bestehend aus einem Ethylenoxidaddukt oder einem Ethylenoxid- und einem Propylenoxidaddukt von Acetylenalkoholen oder Acetylenglykolen, Polyoxyethylenpetrolether, Polyethylenglykoldioleylester, Polyoxyethylenalkylaminoether und einem Blockcopolymer aus Polyethylenglykol und Polypropylenglykol.

5. Verfahren zur Herstellung eines Resistmusters, umfassend den Schritt der Durchführung einer Spülbehandlung eines Resistmusters nach der Entwicklung, **dadurch gekennzeichnet, dass** die Spülflüssigkeit für die Lithographie eine Lösung gemäß einem der Ansprüche 1 bis 4 ist.

6. Verfahren zur Herstellung eines Resistmusters gemäß Anspruch 5, **dadurch gekennzeichnet, dass** die Resistmuster ein Resistmuster mit einer Musterabmessung von 300 nm oder weniger enthalten.

7. Verfahren zur Herstellung eines Resistmuster gemäß Anspruch 5 oder 6, **dadurch gekennzeichnet, dass** das Resistmuster in einem Lithographie-Verfahren ausgebildet wird, umfassend die Belichtung bei einer Belichtungswellenlänge von höchstens 250 nm.

## Revendications

1. Utilisation d'une solution, comprenant de l'eau et un tensioactif non ionique possédant un groupe éthylèneoxy (-CH₂CH₂O-) mais sans atome de fluor, en lithographie, pour exécuter un traitement de rinçage d'un modèle de réserve après développement.

2. Utilisation selon la revendication 1, **caractérisée en ce que** la solution comprend de l'eau, le tensioactif non ionique et, en option, un solvant organique soluble dans l'eau.

3. Utilisation selon la revendication 1 ou 2, **caractérisée en ce que** la concentration du tensioactif non ionique décrit ci-dessus est comprise entre 20 et 5000 ppm.

4. Utilisation selon l'une quelconque des revendications 1 à 3, **caractérisée en ce que** le tensioactif non ionique est au moins un membre sélectionné dans le groupe comprenant un adduct d'oxyde d'éthylène ou un oxyde d'éthylène et un adduct d'oxyde de propylène d'alcools d'acétylène ou de glycols d'acétylène, un éther d'huile de ricin polyoxyéthylénique, un ester dioléylique de polyéthylène glycol, un éther alkylamino de polyoxyéthylène et un copolymère séquencé de polyéthylène glycol et de polypropylène glycol.

5. Méthode de formation du modèle de réserve comprenant l'étape d'exécution d'un traitement de rinçage d'un modèle de réserve après développement, **caractérisée en ce que** la solution de rinçage pour lithographie est une solution selon l'une quelconque des revendications 1 à 4.

6. Méthode de formation du modèle de réserve selon la revendication 5, **caractérisée en ce que** les modèles de réserve contiennent un modèle de réserve possédant une dimension de modèle égale ou inférieure à 300 nm.

7. Méthode de formation du modèle de réserve selon la revendication 5 ou 6, **caractérisée en ce que** le modèle de réserve est formé dans un procédé lithographique comprenant une exposition à la lumière sous une longueur d'onde d'exposition à la lumière égale ou inférieure à 250 nm.
